# EUROPÄISCHE PATENTSCHRIFT

(11) **EP 3 747 098 B1**
(45) Veröffentlichungstag und Bekanntmachung des Hinweises auf die Patenterteilung: **16.10.2024**
(21) Anmeldenummer: 19702439.1
(22) Anmeldetag: 30.01.2019
(51) Int. Cl.: H02H 1/00, H02H 3/04, H02H 3/08, H02H 3/093, H02H 3/20, H02H 3/40, G01R 31/08, E04H 5/04, H02B 7/06, G05B 19/042, H01H 9/16, H01H 85/30, H02J 13/00

(54) **FEHLERDETEKTIONSVORRICHTUNG EINER ORTSNETZSTATION UND EINRICHTUNG ZUR MELDUNG EINES FEHLERS AN EINE ZENTRALE STEUERVORRICHTUNG**
FAULT DETECTION APPARATUS OF A LOCAL SUBSTATION AND DEVICE FOR REPORTING A FAULT TO A CENTRAL CONTROL APPARATUS
DISPOSITIF DE DÉTECTION DE DÉFAUT D'UNE STATION DE RÉSEAU LOCAL ET SYSTÈME D'ANNONCE D'UN DÉFAUT À UN DISPOSITIF DE COMMANDE CENTRAL

(30) Priorität: 02.02.2018 DE 102018102394
(43) Veröffentlichungstag der Anmeldung: 09.12.2020
(73) Patentinhaber: Westnetz GmbH, 44139 Dortmund (DE)
(72) Erfinder: KUGEL, Torsten, 22337 Hamburg (DE)
(74) Vertreter: Cohausz & Florack
(86) Internationale Anmeldenummer: PCT/EP2019/052255
(87) Internationale Veröffentlichungsnummer: WO 2019/149755

(56) Entgegenhaltungen:
- EP-A1- 3 273 459

## Beschreibung

Die Anmeldung betrifft eine Fehlerdetektionsvorrichtung einer Ortsnetzstation zum Detektieren eines Netzfehlers in mindestens einem an der Ortsnetzstation angeschlossenen Niederspannungsnetz. Darüber hinaus betrifft die Anmeldung eine Ortsnetzstation und ein Verfahren zum Betreiben einer Fehlerdetektionsvorrichtung einer Ortsnetzstation. Dokument EP 3 273 459 A1 offenbart eine Fehlererkennungsvorrichtung in einer Ortsnetzstation.

Niederspannungsnetze bzw. Energieverteilnetze sind in der Regel über Ortsnetzstationen mit einem Energienetz höherer Spannung (z.B. Mittelspannungsnetz, Hochspannungsnetz etc.) verbunden. Eine derartige Ortsnetzstation umfasst mindestens eine Transformatoreinrichtung, beispielweise eine Mittelspannungsschaltanlage (oder dergleichen), und mindestens eine Niederspannungsverteileinrichtung. Das Niederspannungsnetz ist insbesondere über die Niederspannungsverteileinrichtung mit der Ortsnetzstation verbunden. Bei einem Niederspannungsnetz kann es im Niederspannungsnetz zu einem Netzfehler, beispielsweise durch einen Erdschluss, kommen. Unter einem Netzfehler ist insbesondere ein Ereignis zu verstehen, das zumindest zu einem Ausfall eines Teils des Niederspannungsnetzes führt.

Problematisch an derartigen Niederspannungsnetzen ist insbesondere, dass der Netzbetreiber einen Netzfehler und damit einen Ausfall von mindestens einem Teil des Niederspannungsnetzes derzeit nur mit einem hohen Aufwand ermitteln kann. So ist der Netzbetreiber zunächst darauf angewiesen, dass ein Kunde bzw. Nutzer des Niederspannungsnetzes (z.B. Nutzer einer an das Niederspannungsnetz angeschlossenen Entität (z.B. Wohnung, Gebäude etc.)) einen Netzfehler dem Netzbetreiber, beispielsweise telefonisch, meldet. Um festzustellen, ob es sich bei dem gemeldeten Netzfehler tatsächlich um einen Netzfehler handelt, muss von dem Netzbetreiber ein Monteur zu dem Niederspannungsnetz ausgesendet werden. Dieser muss dann vor Ort überprüfen, ob tatsächlich ein Netzfehler und ein Teilausfall des Niederspannungsnetzes vorliegen.

Daher liegt der Anmeldung die Aufgabe zugrunde, eine Fehlerdetektionsvorrichtung bereitzustellen, welche in einfacher Weise die Detektion eines Netzfehlers in einem Niederspannungsnetz ermöglicht.

Die Erfindung bezieht sich auf eine Fehlerdetektionsvorrichtung einer Ortsnetzstation gemäß Anspruch 1 und ein Verfahren zum Betreiben einer Fehlerdetektionsvorrichtung einer Ortsnetzstation gemäß Anspruch 10. Bevorzugte Ausführungsformen sind in den abhängigen Ansprüchen definiert.

Fehlerdetektionsvorrichtung umfasst mindestens eine Erfassungseinrichtung, eingerichtet zum Erfassen eines Netzstroms des angeschlossenen Niederspannungsnetzes und/oder einer Netzspannung des angeschlossenen Niederspannungsnetzes. Die Fehlerdetektionsvorrichtung umfasst mindestens eine Speichereinrichtung, eingerichtet zum Speichern von mindestens einem Fehlerkriterium. Die Fehlerdetektionsvorrichtung umfasst mindestens eine Detektionseinrichtung, eingerichtet zum Detektieren eines Netzfehlers basierend auf dem mindestens einen gespeicherten Fehlerkriterium und dem erfassten Netzstrom und/oder der erfassten Netzspannung.

Indem im Gegensatz zum Stand der Technik anmeldungsgemäß eine Fehlerdetektionsvorrichtung einer Ortsnetzstation zum Detektieren eines Netzfehlers in mindestens einem an der Ortsnetzstation angeschlossenem Niederspannungsnetz bereitgestellt wird, wird erstmalig eine automatische Detektion eines Netzfehlers in einem Niederspannungsnetz ermöglicht. Ein Netzbetreiber ist nicht mehr auf eine Benachrichtigung durch einen Kunden/Nutzer des Niederspannungsnetzes angewiesen. Insbesondere wird anmeldungsgemäß ein Netzfehler durch Auswerten von vorab gespeicherten Fehlerkriterien und dem in der Ortsnetzstation erfassten Netzstrom und/oder der in der Ortsnetzstation erfassten Netzspannung detektiert. Anmeldungsgemäß wird eine Fehlerdetektionsvorrichtung einer Ortsnetzstation bereitgestellt. Unter einer Ortsnetzstation ist vorliegend eine (stationäre) Vorrichtung zu verstehen, die elektrisch mit mindestens einem Niederspannungsnetz und mindestens einem Spannungsnetz mit einer höheren Spannungsebene (vorzugsweise ein Mittelspannungsnetz) verbunden ist. Eine anmeldungsgemäße Ortsnetzstation umfasst mindestens eine Transformatoreinrichtung, um die Spannung von einer ersten Spannungsebene (z.B. Mittelspannungsebene von 10 kV, 20 kV oder 30 kV) auf eine weitere Spannungsebene, insbesondere eine Niederspannungsebene (z.B. < 1 kV), zu transformieren. Eine Ortsnetzstation kann beispielsweise über ein Gehäuse verfügen, in dem die elektrischen Komponenten, wie die Transformatoreinrichtung, der Ortsnetzstation angeordnet sind.

Unter einer Fehlerdetektionsvorrichtung einer Ortsnetzstation ist vorliegend eine Fehlerdetektionsvorrichtung zu verstehen, die in der Ortsnetzstation, insbesondere in dem Gehäuse der Ortsnetzstation, integrierbar ist. Insbesondere ist die anmeldungsgemäße Fehlerdetektionsvorrichtung im bestimmungsgemäßen Betrieb in der Ortsnetzstation integriert.

Bei einem anmeldungsgemäßen Niederspannungsnetz handelt es sich um ein Energieverteilnetz mit einer Spannung von zumindest kleiner 1 kV (z.B. 400 V). An dem Niederspannungsnetz kann mindestens eine Entität mit mindestens einem elektrischen Verbraucher, Erzeuger und/oder Speicher angeschlossen sein. Das Niederspannungsnetz kann über eine Mehrzahl von Niederspannungsverteilsträngen verfügen.

Die Fehlerdetektionsvorrichtung umfasst mindestens eine Erfassungseinrichtung, um insbesondere in der Ortsnetzstation, vorzugsweise an einem Niederspannungsanschluss der Transformatoreinrichtung, einen Netzstrom des Niederspannungsnetzes und/oder eine Netzspannung des Niederspannungsnetzes zu erfassen. Bevorzugt kann die Erfassungseinrichtung zumindest die Netzspannung und den Netzstrom erfassen, insbesondere messen. Zusätzlich können weitere elektrische Netzparameter (z.B. Netzfrequenz, Temperatur etc.) durch die Erfassungseinrichtung erfasst werden. Die Erfassung des Netzstroms und/oder der Netzspannung kann vorzugsweise nahezu kontinuierlich durchgeführt werden.

Darüber hinaus weist die Fehlerdetektionsvorrichtung mindestens eine Speichereinrichtung auf, die zum Speichern von Daten eingerichtet ist. Insbesondere ist in der Speichereinrichtung mindestens ein (vorgegebenes) Fehlerkriterium gespeichert. Ein Fehlerkriterium kann insbesondere das Verhalten eines Netzstroms bei einem Auftreten eines Netzfehlers und/oder das Verhalten einer Netzspannung bei einem Auftreten eines Netzfehlers repräsentieren. Beispielsweise kann das mindestens eine entsprechende Fehlerkriterium in vorherigen Tests bestimmt worden sein.

Ferner weist die Fehlerdetektionsvorrichtung mindestens eine Detektionseinrichtung auf, um mindestens einen Netzfehler zu detektieren bzw. zu bestimmen. Insbesondere kann die Detektionseinrichtung basierend auf einer Auswertung des erfassten Netzstroms und/oder der erfassten Netzspannung und des mindestens einen gespeicherten Fehlerkriteriums durchgeführt werden. In einfacher Weise kann eine Überwachung eines Niederspannungsnetzes bereitgestellt werden.

Gemäß einer ersten Ausführungsform der anmeldungsgemäßen Fehlerdetektionsvorrichtung kann die Detektionseinrichtung zum Detektieren eines Netzfehlers basierend auf einem Vergleich zwischen dem mindestens einen gespeicherten Fehlerkriterium und dem erfassten Netzstrom und/oder der erfassten Netzspannung eingerichtet sein. Wie bereits beschrieben wurde, kann das mindestens eine Fehlerkriterium das Verhalten eines Netzstroms bei einem Auftreten eines Netzfehlers und/oder das Verhalten einer Netzspannung bei einem Auftreten eines Netzfehlers repräsentieren. Indem ein erfasster Netzstrom und/oder eine erfasste Netzspannung mit einem entsprechenden Fehlerkriterium verglichen wird, kann ein Netzfehler und ein damit einhergehender Ausfall von zumindest einem Teil des überwachten Niederspannungsnetzes in einfacher und sicherer Weise bestimmt bzw. detektiert werden.

Gemäß einer bevorzugten Ausführungsform kann das mindestens eine gespeicherte Fehlerkriterium eine Fehlerkennlinie, insbesondere eine Fehlerstromkennlinie und/oder eine Fehlerspannungskennlinie, und/oder ein Fehlerimpedanzsprung sein. Insbesondere kann die Fehlerstromkennlinie ein Netzstromverhalten bei Auftreten eines Netzfehlers repräsentieren. Ebenso kann eine Fehlerspannungskennlinie ein Netzspannungsverhalten bei Auftreten eines Netzfehlers repräsentieren. Entsprechendes gilt für einen Fehlerimpedanzsprung.

Alternativ oder vorzugsweise zusätzlich kann der erfasste Netzstrom ein erfasster Netzstromverlauf und/oder die erfasste Netzspannung ein erfasster Netzspannungsverlauf sein. Vorzugsweise kann der Netzstromverlauf des überwachten Niederspannungsnetzes und/oder der Netzspannungsverlauf des überwachten Niederspannungsnetzes kontinuierlich erfasst werden. Ein entsprechender Verlauf kann insbesondere mit einer zuvor beschriebenen Fehlerkennlinie verglichen werden. Beispielsweise kann ein Netzfehler bestimmt werden, wenn ein erfasster Verlauf im Wesentlichen einer gespeicherten Fehlerkennlinie entspricht. Insbesondere kann eine Mehrzahl von unterschiedlichen Fehlerkennlinien und/oder Fehlerimpedanzsprüngen in der Speichereinrichtung gespeichert sein, um insbesondere eine Mehrzahl von unterschiedlichen Netzfehlern detektieren zu können.

Wie bereits beschrieben wurde, kann das Fehlerkriterium, beispielsweise eine Fehlerkennlinie, das Verhalten des Netzstrom(s) (verlaufs) und/oder der/des Netzspannung(s) (verlaufs) bei einem Auftreten eines Netzstromfehlers und/oder eines Netzstromspannungsfehlers repräsentieren bzw. entsprechen. Insbesondere kann eine Fehlerkennlinie einen typischen und beispielsweise durch Tests ermittelten Verlauf eines Netzstroms und/oder einer Netzspannung bei einem Auftritt eines (bestimmten) Netzfehlers darstellen. Vorzugsweise können für unterschiedliche Fehlerarten entsprechende Fehlerkennlinien vorab bestimmt und insbesondere abgespeichert werden.

Gemäß einer bevorzugten Ausführungsform kann das mindestens eine Fehlerkriterium einen durch einen Netzfehler bewirkten Schaltvorgang (und daraus resultierenden Netzstromverlauf und/oder Netzspannungsverlauf) eines Betriebsmittels des Niederspannungsnetzes repräsentieren. Indem ein entsprechendes Fehlerkriterium gespeichert ist, kann nicht nur ein Netzfehler grundsätzlich detektiert werden, sondern ein detektierter Netzfehler einer bestimmten Netzfehlerart, also insbesondere einem bestimmten Betriebsmittel des Niederspannungsnetz zugeordnet werden. Unter einem Betriebsmittel des Niederspannungsnetzes ist insbesondere eine elektrische Komponente des Niederspannungsnetzes zu verstehen, die nicht in einer Entität angeordnet ist, die an dem Niederspannungsnetz angeschlossen ist.

Alternativ oder zusätzlich kann gemäß einer Ausführungsform das mindestens eine Fehlerkriterium einen durch einen Netzfehler bewirkten Schaltvorgang (und daraus resultierenden Netzstromverlauf und/oder Netzspannungsverlauf) eines Betriebsmittels einer an das Niederspannungsnetz angeschlossenen Entität repräsentieren. Indem ein entsprechendes Fehlerkriterium gespeichert ist, kann nicht nur ein Netzfehler grundsätzlich detektiert werden, sondern ein Netzfehler einer bestimmten Fehlerart, also insbesondere einem bestimmten Betriebsmittel einer (bestimmten) Entität zugeordnet werden. Unter einem Betriebsmittel einer Entität ist insbesondere eine elektrische Komponente der Entität zu verstehen, die in einer Entität angeordnet ist, die an dem Niederspannungsnetz angeschlossen ist.

Besonders bevorzugt kann das Betriebsmittel des Niederspannungsnetzes eine an einer Niederspannungsverteilsammelschiene der Ortsnetzstation angeschlossene (Schmelz-)Sicherung, insbesondere eine Niederspannungs-Hochleistungs-Sicherung, sein. Insbesondere kann eine zuvor beschriebene Fehlerkennlinie in Form einer Auslösekennlinie einer entsprechenden Sicherung vorgesehen sein oder auf dieser basieren. Mit anderen Worten repräsentiert das Fehlerkriterium das Netzstromverhalten und/oder Netzspannungsverhalten bei einer Auslösung der Sicherung. Insbesondere ist festgestellt worden, dass eine in einer Ortsnetzstation verbaute Niederspannungs-Hochleistungs-Sicherung einen charakteristischen Auslöseverlauf bewirkt, der in der Regel nur bei einer Auslösung einer entsprechenden Sicherung auftritt. Insbesondere unterscheidet sich im fehlerfreien Betrieb der Netzstromverlauf und/oder der Netzspannungsverlauf (stets) von einem Netzstromverlauf und/oder der Netzspannungsverlauf bei einer Auslösung einer entsprechenden Sicherung. Dies ermöglicht die Detektion eines entsprechenden Netzfehlers, da nur bestimmte Netzfehler zu einer Auslösung führen. Insbesondere führen Netzfehler in einer Entität nicht zu einer entsprechenden Auslösung.

Gemäß einer weiteren Ausführungsform kann die Erfassungseinrichtung ein Strommessmodul, insbesondere ein digitales Strommessmodul (mit einer geeigneten Abtastrate (z.B. im kHz Bereich)), umfassen. Das Strommessmodul kann zum Erfassen des mindestens einen über eine Niederspannungsverteilsammelschiene der Ortsnetzstation fließenden Netzstroms eingerichtet sein.

Alternativ oder vorzugsweise zusätzlich kann die Erfassungseinrichtung ein Spannungsmessmodul, insbesondere ein digitales Spannungsmessmodul (mit einer geeigneten Abtastrate(z.B. im kHz Bereich)), umfassen. Das Spannungsmessmodul kann zum Erfassen der mindestens einen an einer Niederspannungsverteilsammelschiene der Ortsnetzstation anliegenden Netzspannung eingerichtet sein.

Die Niederspannungsverteilsammelschiene kann die von der mindestens einen Transformatoreinrichtung bereitgestellte Spannung bzw. den bereitgestellten Strom auf vorzugsweise eine Mehrzahl von Niederspannungsnetzverteilersträngen verteilen. Jeder Verteilstrang kann jeweils über mindestens eine zuvor beschriebene Sicherung verfügen. Bei einem mehrphasigen Verteilstrang kann jede Phase über eine entsprechende Sicherung abgesichert sein. Insbesondere kann eine Niederspannungsverteilsammelschiene in der Ortsnetzstation und insbesondere an einem Ausgang der Transformatoreinrichtung angeordnet sein. Indem ein Netzstrom und/oder eine Netzspannung an der Niederspannungsverteilsammelschiene gemessen wird, kann in besonders einfacher Weise ein Netzstrom und/oder eine Netzspannung des zu überwachenden Niederspannungsnetzes erfasst werden.

Bei Detektion eines Netzfehlers kann insbesondere eine Fehlermeldung von der Fehlerdetektionsvorrichtung abgegeben werden. Gemäß einer Ausführungsform kann die Fehlerdetektionsvorrichtung mindestens eine mit der Detektionseinrichtung koppelbare Kommunikationseinrichtung umfassen. Die Kommunikationseinrichtung kann zum Aussenden einer Netzfehlernachricht über ein Kommunikationsnetz bei Detektion eines Netzfehlers eingerichtet sein. Das Kommunikationsnetz kann ein drahtgebundenes und/oder drahtloses Kommunikationsnetz sein. Die Netzfehlernachricht kann zumindest eine Information über die Detektion eines Netzfehlers (Netzfehlerauftrittsinformation) umfassen. Vorzugsweise kann die Netzfehlernachricht - wenn eine Netzfehlerart bzw. ein ausgelöstes Betriebsmittel bestimmt worden ist - eine Information hierüber umfassen. Alternativ oder zusätzlich kann in der Netzfehlernachricht mindestens eine Information über die (voraussichtliche) Position des Netzfehlers enthalten sein.

Insbesondere kann die Netzfehlernachricht in Form eines Netzfehlerdatensatzes gebildet sein, der zumindest eine der folgenden Informationen/Daten zumindest implizit umfasst:
- Netzfehlerauftritt,
- Netzfehlerart bzw. Betriebsmittelkennung,
- Ortsnetzstationskennung,
- Niederspannungsnetzkennung,
- Fehlerdetektionsvorrichtungskennung,
- Positionsdaten des Netzfehlers (geographische Koordinationsdaten oder ähnliche Daten),
- Zeitstempel, und
- Niederspannungsnetzstrangkennung.

Um die Position eines Netzfehlers bzw. den Netzfehlerort zu bestimmen, kann gemäß einer weiteren Ausführungsform einer anmeldungsgemäßen Fehlerdetektionsvorrichtung die Fehlerdetektionsvorrichtung mindestens eine Fehlerortbestimmungseinrichtung umfassen. Die Fehlerortbestimmungseinrichtung, insbesondere umfassend ein Entfernungsmessmodul, kann zumindest zum Bestimmen des Abstands bzw. der Entfernung zwischen dem Ort des detektierten Netzfehlers (z.B. ein Kurzschlussfehler) und der Fehlerortbestimmungseinrichtung eingerichtet sein. Hiermit kann insbesondere die Position eines außerhalb der Ortsnetzstation aufgetretenen Netzfehlers näher bestimmt werden.

Ein weiterer Aspekt der Anmeldung ist eine Ortsnetzstation, umfassend mindestens eine Transformatoreinrichtung, und mindestens eine zuvor beschriebene Fehlerdetektionsvorrichtung. Die Fehlerdetektionsvorrichtung kann vorzugsweise in einem Gehäuse der Ortsnetzstation integriert sein.

Ein noch weiterer Aspekt der Anmeldung ist ein System, umfassend mindestens eine zuvor beschriebene Ortsnetzstation und mindestens eine zentrale Steuervorrichtung. Vorzugsweise kann eine Mehrzahl von zuvor beschriebenen Ortsnetzstationen vorgesehen sein. Wie bereits beschrieben wurde, kann eine anmeldungsgemäße Ortsnetzstation eine zuvor beschriebene Fehlerdetektionsvorrichtung umfassen, die mittels einer zuvor beschriebenen Kommunikationseinrichtung insbesondere mit der (entfernt von der Ortsnetzstation angeordneten) zentralen Steuervorrichtung kommunizieren kann. Hierdurch können eine Vielzahl von Niederspannungsnetzen durch eine zentrale Steuervorrichtungen und den jeweiligen anmeldungsgemäßen Ortsnetzstationen in einfacher Weise überwacht werden.

Ein noch weiterer Aspekt der Anmeldung ist ein Verfahren zum Betreiben einer Fehlerdetektionsvorrichtung einer Ortsnetzstation, insbesondere einer zuvor beschriebenen Fehlerdetektionsvorrichtung und/oder einer zuvor beschriebenen Ortsnetzstation. Das Verfahren umfasst:
- Erfassen eines Netzstroms eines an der Ortsnetzstation angeschlossenen Niederspannungsnetzes und/oder einer Netzspannung eines an der Ortsnetzstation angeschlossenen Niederspannungsnetzes,
- wobei mindestens ein Fehlerkriterium in mindestens einer Speichereinrichtung gespeichert ist, und
- Detektieren eines Netzfehlers in dem angeschlossenen Niederspannungsnetz basierend auf dem mindestens einen gespeicherten Fehlerkriterium und dem erfassten Netzstrom und/oder der erfassten Netzspannung.

Es sei angemerkt, dass vorliegend eine Einrichtung und/oder ein Modul zumindest teilweise aus Hardware- und/oder zumindest teilweise aus Softwarekomponenten gebildet sein kann/können.

Die Merkmale der Vorrichtungen, Stationen, Systeme und Verfahren sind frei miteinander kombinierbar. Insbesondere können Merkmale der Beschreibung und/oder der abhängigen Ansprüche, auch unter vollständiger oder teilweiser Umgehung von Merkmalen der unabhängigen Ansprüche, in Alleinstellung oder frei miteinander kombiniert eigenständig erfinderisch sein.

Es gibt nun eine Vielzahl von Möglichkeiten, die anmeldungsgemäße Fehlerdetektionsvorrichtung, die anmeldungsgemäße Ortsnetzstation und das anmeldungsgemäße Verfahren auszugestalten und weiterzuentwickeln. Hierzu sei einerseits verwiesen auf die den unabhängigen Patentansprüchen nachgeordneten Patentansprüche, andererseits auf die Beschreibung von Ausführungsbeispielen in Verbindung mit der Zeichnung. In der Zeichnung zeigt:
- Fig. 1: eine schematische Ansicht eines Ausführungsbeispiels einer Fehlerdetektionsvorrichtung gemäß der vorliegenden Anmeldung,
- Fig. 2: eine schematische Ansicht eines weiteren Ausführungsbeispiels einer Fehlerdetektionsvorrichtung gemäß der vorliegenden Anmeldung,
- Fig. 3: ein Diagramm eines Ausführungsbeispiels eines Verfahrens gemäß der vorliegenden Anmeldung, und
- Fig. 4: eine schematische Ansicht eines beispielhaften Fehlerkriteriums, insbesondere in Form einer Fehlerkennlinie, gemäß der vorliegenden Anmeldung.

Nachfolgend werden für gleiche Elemente gleiche Bezugszeichen verwendet.

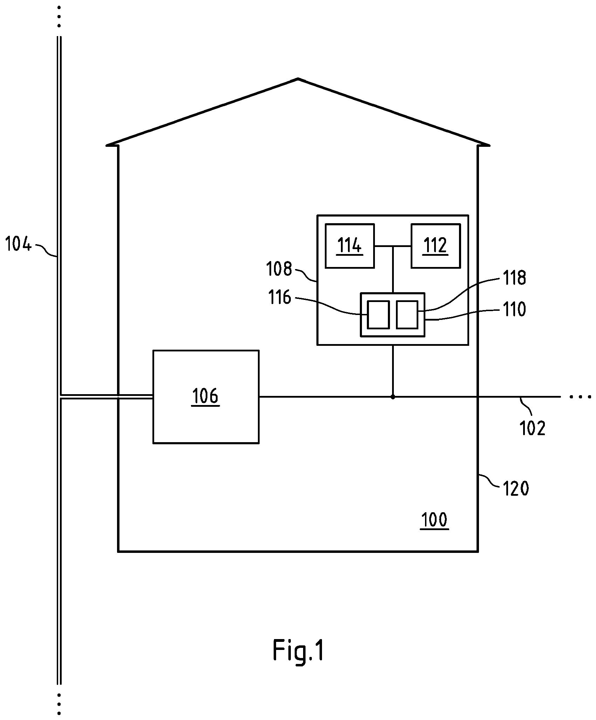

Die Figur 1 zeigt eine schematische Ansicht eines Ausführungsbeispiels einer Fehlerdetektionsvorrichtung 108 einer Ortsnetzstation 100. Insbesondere ist die Fehlerdetektionsvorrichtung 108 im bestimmungsgemäßen Betrieb in der Ortsnetzstation 100 angeordnet.

Das dargestellte Ausführungsbeispiel einer anmeldungsgemäßen Ortsnetzstation 100 kann ein Gehäuse 120, insbesondere in Form eines Gebäudes 120, aufweisen. Die Ortnetzstation 100 umfasst mindestens eine Transformatoreinrichtung 106 bzw. mindestens einen Transformator 106. Beispielsweise kann die Ortsnetzstation 100 an ein Mittelspannungsnetz 104 angebunden sein. Es versteht sich, dass anstelle des mindestens einen Mittelspannungsnetzes 104 auch ein Energienetz höherer Spannung vorgesehen sein kann.

Beispielsweise kann das Mittelspannungsnetz 104 über eine (nicht gezeigte) Mittelspannungsschaltanlage mit einem Eingang der mindestens einen Transformatoreinrichtung 106 elektrisch verbunden sein. Die Ortsnetzstation 100 ist ferner mit mindestens einem Niederspannungsnetz (Spannung zumindest < 1 kV, z.B. 400 V) 102 verbunden. Insbesondere ist der Ausgang der mindestens einen Transformatoreinrichtung 106 elektrisch, beispielsweise über eine (nicht detailliert dargestellte) Niederspannungsverteileinrichtung, mit dem Niederspannungsnetz 102 verbunden. Die Transformatoreinrichtung transformiert insbesondere die am Eingang anliegende Spannung auf die gewünschte Spannung (z.B. 400 V) des Niederspannungsnetzes 102

Ferner umfasst die Ortsnetzstation 100 vorliegend eine Fehlerdetektionsvorrichtung 108. Insbesondere ist die Fehlerdetektionsvorrichtung 108 in der Ortsnetzstation 100, also vorzugsweise in dem Gehäuse 120 der Ortsnetzstation 100, integriert. Wie zu erkennen ist, weist die vorliegende Fehlerdetektionsvorrichtung 108 drei Einrichtungen 110, 112, 114 auf. Insbesondere umfasst die Fehlerdetektionsvorrichtung 108 eine Erfassungseinrichtung 110, eine Speichereinrichtung 114 und eine Detektionseinrichtung 112. Die Erfassungseinrichtung 110 umfasst vorliegend ein Stromessmodul 116, insbesondere ein digitales Strommessmodul 116, und mindestens ein Spannungsmessmodul 118, insbesondere ein digitales Spannungsmessmodul 118. Bevorzugt kann eine ohnehin in der Ortsnetzstation 100 vorgesehene Erfassungseinrichtung 110 mit mindestens einem digitalen Strommessmodul 116 und mindestens einem digitalen Spannungsmessmodul 118 eingesetzt werden.

Die Erfassungseinrichtung 110 ist insbesondere eingerichtet, mindestens einen elektrischen Parameter, insbesondere den Netzstrom und/oder die Netzspannung des Niederspannungsnetzes 102, (nahezu) kontinuierlich zu erfassen. Beispielsweise können die digitalen Messmodule 116, 118 mit einer geeigneten Abtastrate (z.B. im kHz Bereich) betrieben werden. Vorzugsweise kann das Strommessmodul 116 einen Netzstromverlauf erfassen und insbesondere bereitstellen. Ferner kann vorzugsweise das Spannungsmessmodul 118 einen Netzspannungsverlauf erfassen und insbesondere bereitstellen.

Insbesondere kann der Netzspannungsverlauf und/oder der Netzstromverlauf von der Erfassungseinrichtung 110 der Detektionseinrichtung 112 bereitgestellt werden.

Die Detektionseinrichtung 112 wertet vorzugsweise den Netzspannungsverlauf und/oder den Netzstromverlauf insbesondere (nahezu) kontinuierlich aus.

Insbesondere kann die Detektionseinrichtung 112 während der Auswertung auf die Speichereinrichtung 114 zugreifen. In der Speichereinrichtung 114 ist mindestens ein Fehlerkriterium gespeichert, welches für mindestens einen potentiellen Netzfehler charakteristisch ist. Vorzugsweise kann das mindestens eine Fehlerkriterium eine Fehlerkennlinie, insbesondere eine Fehlerstromkennlinie und/oder Fehlerspannungskennlinie, und/oder ein Fehlerimpedanzsprung sein, die/der bei einem Auftreten eines Netzfehlers einem aus dem Netzfehler resultierenden Netzstromverlauf und/oder Netzspannungsverlauf entspricht.

Die Detektionseinrichtung 112 ist insbesondere eingerichtet, den bereitgestellten Netzspannungsverlauf und/oder den bereitgestellten Netzstromverlauf mit dem mindestens einen Fehlerkriterium zu vergleichen. Wird ein Abgleich zwischen dem augenblicklich erfassten Netzspannungsverlauf und/oder dem augenblicklich erfassten Netzstromverlauf und einem gespeicherten Fehlerkriterium, wie eine gespeicherte Fehlerkennlinie, detektiert, so wird von der Detektionseinrichtung 112 ein Netzfehler detektiert bzw. bestimmt. Beispielsweise kann dann eine Fehlermeldung von der Detektionseinrichtung 112 erzeugt und insbesondere abgegeben werden.

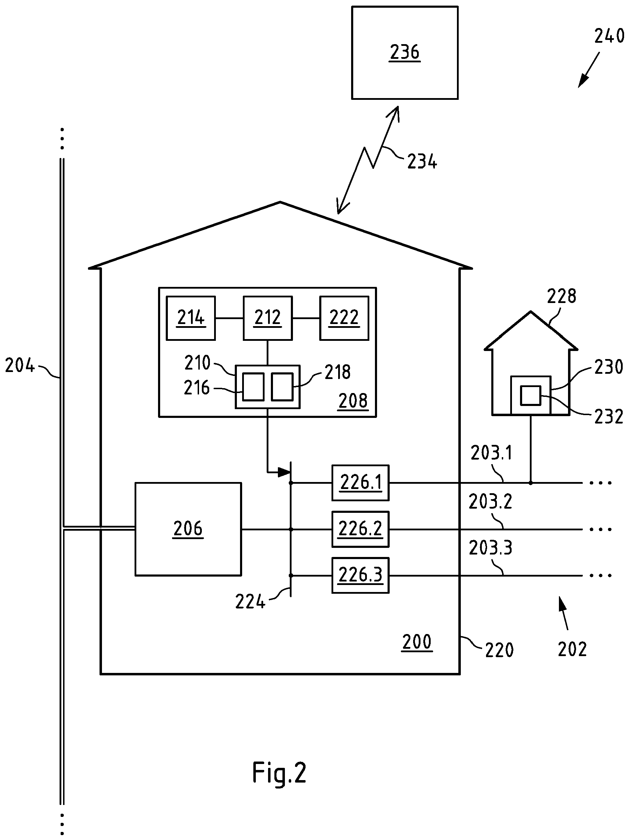

Die Figur 2 zeigt eine schematische Ansicht eines weiteren Ausführungsbeispiels einer Fehlerdetektionsvorrichtung 208 in einer beispielhaften Ortsnetzstation 200 gemäß der vorliegenden Anmeldung. Zur Vermeidung von Wiederholungen werden nachfolgend im Wesentlichen nur die Unterschiede zu dem Ausführungsbeispiel nach Figur 1 beschrieben. Für die anderen Komponenten der Fehlerdetektionsvorrichtung 208 und/oder der Ortsnetzstation 200 wird insbesondere auf die obigen Ausführungen verwiesen.

Wie zu erkennen ist, umfasst das dargestellte Ausführungsbeispiel eines anmeldungsgemäßen Systems 240 eine Ortsnetzstation 200 und mindestens eine, vorzugsweise zentrale, Steuervorrichtung 236. Die zentrale Steuervorrichtung kann zumindest zum Überwachen von mindestens einem Niederspannungsnetz 202 eingesetzt werden.

Die vorliegende Fehlerdetektionsvorrichtung 208 umfasst mindestens eine Kommunikationseinrichtung 222. Die dargestellte Kommunikationseinrichtung 222 ist insbesondere zum Kommunizieren mit der zentralen Steuervorrichtung 236 über ein Kommunikationsnetz 234, vorliegend ein drahtlos ausgebildetes Kommunikationsnetz 234, eingerichtet. Es versteht sich, dass andere Kommunikationsnetzarten alternativ oder zusätzlich verwendet werden können.

Vorzugsweise kann die Kommunikationseinrichtung 222 für eine bidirektionale Kommunikation ausgelegt sein. Beispielsweise kann die Kommunikationseinrichtung 222 erzeugte Netzfehlernachrichten an die zentrale Steuervorrichtung 236 übertragen und/oder Datensätze, zum Beispiel Software-Updates, von der zentralen Steuervorrichtung 236 (oder einer anderen, nicht dargestellten Vorrichtung) empfangen. Es versteht sich, dass weitere Daten ausgetauscht werden können.

Wie zu erkennen ist, umfasst die Ortsnetzstation 200 mindestens eine Transformatoreinrichtung 206. Vorzugsweise kann zwischen der Transformatoreinrichtung 206 und dem Niederspannungsnetz 202 eine Niederspannungsverteileinrichtung 224, insbesondere in Form einer Niederspannungsverteilsammelschiene 224, angeordnet sein. Besonders bevorzugt sind an der Niederspannungsverteilsammelschiene 224 eine Mehrzahl von Sicherungen 226.1 bis 226.3, insbesondere NH-Sicherungen 226.1 bis 226.3, angeordnet. Die von dem Mittelspannungsnetz bereitgestellte Leistung bzw. Strom und Spannung können von der Niederspannungsverteilsammelschiene 224 und über die jeweiligen NH-Sicherungen 226.1 bis 226.3 vorzugsweise auf eine Mehrzahl von Niederspannungsverteilsträngen 203.1 bis 203.3 des Niederspannungsnetzes 202 verteilt werden. Es versteht sich, dass jede Phase eines Verteilstrangs 203.1 bis 203.3 durch eine entsprechende Sicherung abgesichert sein kann. Ferner versteht es sich, dass mehr oder weniger als die beispielhaft dargestellten drei Verteilstränge vorgesehen sein können.

Gemäß anderen Varianten der Anmeldung können Sicherungen, insbesondere NH-Sicherungen, (vorzugsweise zusätzlich zu den Sicherungen 203.1 bis 203.3 und/oder 232) im Niederspannungsnetz, insbesondere gestaffelt, angeordnet sein. Beispielsweise kann mindestens eine derartige Sicherung in mindestens einem Kabelverteilschrank des Niederspannungsnetzes verbaut sein.

An einem Verteilerstrang 203.1 bis 203.3 kann/können jeweils mindestens ein elektrischer Verbraucher und/oder mindestens ein elektrischer Erzeuger und/oder mindestens ein elektrischer Speicher anschließbar sein. Beispielhaft ist eine an den ersten Verteilerstrang 203.1 angeschlossene Entität 228, insbesondere in Form eines Gebäudes 228, dargestellt. Die Entität 228 kann beispielsweise mindestens einen (nicht dargestellten) elektrischen Verbraucher, Erzeuger und/oder Speicher umfassen.

Gemäß anderen Varianten der Anmeldung kann es sich bei dem mindestens einen Verteilerstrang des Niederspannungsnetzes um einen leer laufenden Verteilerstrang handeln. Es ist mit anderen Worten möglich, dass an einem Niederspannungsnetz keine Entität angeschlossen ist.

Ein Netzfehler kann beispielsweise im Netz selber auftreten (z.B. Kabelfehler, ein auf eine Freileitung gestürzter Baum etc.). Mit anderen Worten muss der Netzfehler nicht nur bei der Entität auftreten.

Über einen Stromanschluss 230 der Entität 228, der eine Absicherung 232, beispielsweise in Form einer Schmelzsicherung 232, umfassen kann, kann die Entität elektrisch mit dem Niederspannungsnetz 202, vorliegend dem ersten Verteilerstrang 203.1, verbunden sein. Die Schmelzsicherung 232 kann sich insbesondere von der zuvor beschriebenen NH-Sicherung 226.1 bis 226.3 umfassen.

Wie zu erkennen ist, messen das Spannungsmessmodul 218 und das Strommessmodul 216 die entsprechenden elektrischen Parameter Netzstrom und Netzspannung bevorzugt an der Niederspannungsverteilsammelschiene 224.

Wie zuvor beschrieben wurde, ist die Detektionseinrichtung 210 zum Detektieren eines Netzfehlers basierend auf mindestens einem gespeicherten Fehlerkriterium und dem erfassten Netzstrom und/oder der erfassten Netzspannung eingerichtet. Insbesondere können hierbei als Fehlerkriterien zwei oder mehr unterschiedliche Fehlerkennlinien für z.B. zwei oder mehr unterschiedliche Netzstrom- oder Netzspannungsverhalten bzw. -verläufe, die jeweils durch unterschiedliche Netzfehler verursacht werden können, gespeichert sein.

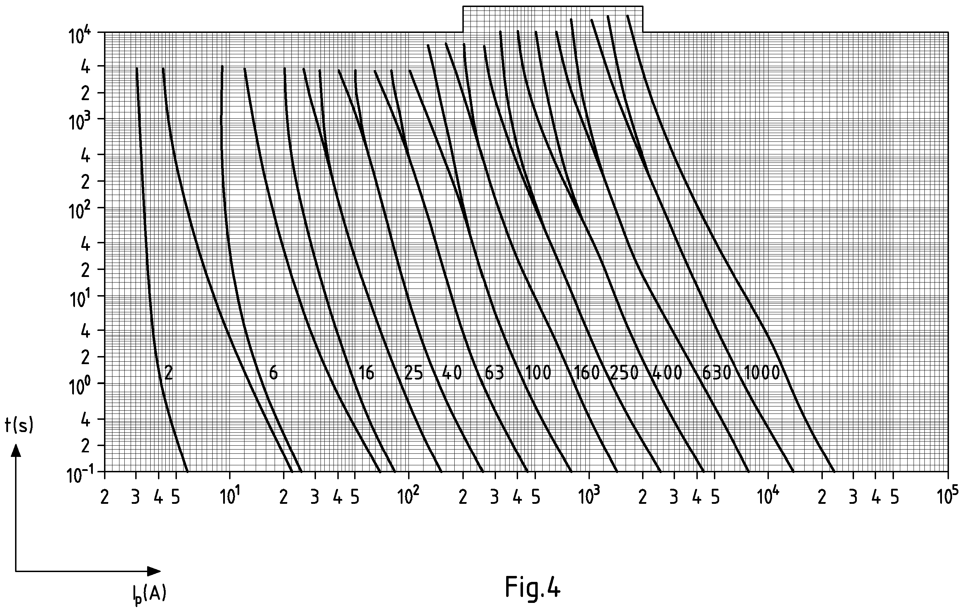

Beispielsweise kann ein erstes Fehlerkriterium auf einer Auslösekennlinie einer NH-Sicherung 226.1 bis 226.3 basieren und gespeichert sein, wobei eine Auslösung einer Sicherung durch einen Netzfehler (z.B. Kurschluss) hervorgerufen werden kann. Beispielhafte Kennlinien von NH-Sicherungen sind in der Figur 4 dargestellt. Dem ersten Fehlerkriterium kann eine entsprechende Fehlerinformation über die Art des Netzfehlers bzw. das ausgelöste Betriebsmittel 226.1 bis 226.3 in Form einer NH-Sicherung 226.1 bis 226.3 zugeordnet sein.

Beispielsweise kann mindestens ein weiteres Fehlerkriterium, beispielsweise basierend auf einer Auslösekennlinie der Absicherung 232, gespeichert sein. Auch in diesem Fall kann dem weiteren Fehlerkriterium in der Speichereinrichtung 214 eine entsprechende Fehlerinformation über die Art des Netzfehlers bzw. das ausgelöste Betriebsmittel 232 der Entität in Form der Absicherung 232 zugeordnet sein.

Die Detektionseinrichtung 212 ist insbesondere eingerichtet, einen erfassten Netzstrom- und/oder Netzspannungsverlauf auszuwerten, indem die Detektionseinrichtung 212 (nahezu kontinuierlich) den mindestens einen erfassten Verlauf mit der mindestens einen Fehlerkennlinie vergleicht. Wenn die Detektionseinrichtung 212 beispielsweise einen im Wesentlichen identischen Verlauf (es versteht sich, dass sich die Amplitudenwerte unterscheiden können) zwischen einem erfassten Verlauf und einer gespeicherten Kennlinie detektiert, kann die Detektionseinrichtung 212 einen Netzfehler detektieren. Dann kann eine Fehlermeldung in Form einer Netzfehlernachricht erzeugt und mittels der Kommunikationseinrichtung 222 ausgesendet werden.

Vorzugsweise kann die Netzfehlernachricht in Form eines zuvor beschriebenen Netzfehlerdatensatzes generiert werden. Der Netzfehlerdatensatz kann insbesondere eine Fehlerinformation über die Art des detektierten Netzfehlers umfassen. Wenn beispielsweise die erste Fehlerkennlinie im Wesentlichen dem augenblicklichen Verlauf entspricht, kann aus der Speichereinrichtung 214 die zusätzliche Information ausgelesen werden, dass eine der Schmelzsicherungen 226.1 bis 226.3 ausgelöst hat. In entsprechender Weise kann bei einer im Wesentlichen Übereinstimmung des augenblicklichen Verlaufs und der mindestens einen weiteren Fehlerkennlinie eine entsprechende Information über den weiteren Netzfehler aus der Speichereinrichtung 214 ausgelesen werden.

Vorteilhafterweise kann nicht nur ein Netzfehler detektiert werden, sondern auch die Netzfehlerart bestimmt werden. Die zentrale Steuervorrichtung 236 kann basierend auf diesen Informationen eine besonders effiziente Entstörung bewirken.

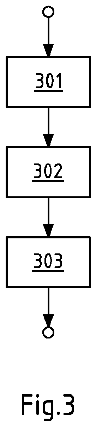

Die Figur 3 zeigt ein Diagramm eines Ausführungsbeispiels eines Verfahrens gemäß der vorliegenden Anmeldung. Das Verfahren kann insbesondere zum Betreiben einer zuvor beschriebenen, beispielhaften Fehlerdetektionsvorrichtung 108, 208 eingesetzt werden.

In einem ersten Schritt 301 wird gemäß dem vorliegenden Ausführungsbeispiel mindestens ein Netzstrom und/oder eine Netzspannung, vorzugsweise - wie zuvor beschrieben wurde - mindestens ein Netzstromverlauf und/oder ein Netzspannungsverlauf (nahezu kontinuierlich) erfasst.

In einem nächsten Schritt 302 kann entsprechend den obigen Ausführungen eine Detektionseinrichtung einen Auswerteschritt durchführen. So wird in Schritt 302 mindestens ein Netzfehler basierend auf dem mindestens einen gespeicherten Fehlerkriterium und dem erfassten Netzstrom und/oder der erfassten Netzspannung detektiert. Insbesondere kann in diesem Schritt ein Vergleich zwischen einem augenblicklichen Verlauf und mindestens einer Fehlerkennlinie durchgeführt werden. Wird hierbei keine ausreichende (z.B. innerhalb vorgebbarer Toleranzwerte) Übereinstimmung detektiert, so wird das Verfahren mit den Schritten 301 und 302 fortgesetzt. Hierbei versteht es sich, dass die Schritte 301 und 302 zumindest nahezu parallel durchgeführt werden können. Insbesondere können die Schritte 301 und 302 (zumindest nahezu) kontinuierlich durchgeführt werden.

Wird in dem Schritt 302 ein Netzfehler detektiert, beispielsweise basierend auf dem zuvor beschriebenen Vergleich, kann in Schritt 303 die Generierung einer Netzfehlernachricht und insbesondere deren Aussendung bewirkt werden. Die Netzfehlernachricht kann - wie zuvor beschrieben wurde - einen Netzfehlerdatensatz umfassen, wobei der Netzfehlerdatensatz zumindest eine (implizite) Information darüber umfassen kann, dass ein Netzfehler detektiert worden ist. Zusätzlich kann die Netzfehlernachricht vorzugsweise eine Information über die Netzfehlerart des detektierten Netzfehlers umfassen.

Alternativ oder zusätzlich kann die Netzfehlernachricht eine Information über den Ort des Netzfehlers umfassen, wie eine (eindeutige) Kennung (z.B. Adresse, Code etc.) der Ortsnetzstation, eine (eindeutige) Kennung (z.B. Adresse, Code etc.) des Niederspannungsnetzes, eine (eindeutige) Kennung (z.B. Adresse, Code etc.) der Fehlerdetektionsvorrichtung und/oder eine (eindeutige) Kennung (z.B. Adresse, Code etc.) der Kommunikationseinrichtung umfassen.

Zusätzlich kann in einem Ausführungsbeispiel eine (nicht gezeigte) Fehlerortbestimmungseinrichtung vorgesehen sein. Die Fehlerortbestimmungseinrichtung kann insbesondere ein Entfernungsmessmodul aufweisen. Das Entfernungsmessmodul kann zum Bestimmen der Entfernung eines detektierten Netzfehlers (z.B. Kurzschluss) zu dem Entfernungsmessmodul eingerichtet sein. Hierbei kann die Fehlerortbestimmungseinrichtung vorzugsweise in der Ortsnetzstation und/oder in der Fehlerdetektionsvorrichtung angeordnet sein. Hierdurch kann beispielsweise der Ort eines Netzfehlers, der durch ein Betriebsmittel einer an das Niederspannungsnetz angeschlossenen Entität erzeugt wurde oder der eine Auslösung eines Betriebsmittels, wie eine zuvor beschriebene Sicherung, bewirkt hat, näher eingegrenzt werden. Auch diese Information (Ort des detektierten Netzfehlers) kann in einer Netzfehlernachricht enthalten sein.

Indem eine Netzfehlernachricht mit einem Netzfehlerdatensatz, der zumindest einen Teil der vorgenannten Informationen (z.B. Netzfehlerart und/oder Netzfehlerort) umfasst, bei Detektion eines Netzfehlers erstellt und ausgesendet wird, kann eine Entstörung zeitnah bewirkt werden. Eine telefonische Benachrichtigung durch eine Kunden oder einen anderen Nutzer kann entfallen. Eine effiziente Überwachung eines Niederspannungsnetzes kann bereitgestellt werden.

## Patentansprüche

1. Fehlerdetektionsvorrichtung (108, 208) einer Ortsnetzstation (100, 200) zum Detektieren eines Netzfehlers in mindestens einem an der Ortsnetzstation (100, 200) angeschlossenen Niederspannungsnetz (102, 202), umfassend:
- mindestens eine Erfassungseinrichtung (110, 210), eingerichtet zum Erfassen eines Netzstroms des angeschlossenen Niederspannungsnetzes (102, 202) und/oder einer Netzspannung des angeschlossenen Niederspannungsnetzes (102, 202),
- mindestens eine Speichereinrichtung (114, 214), eingerichtet zum Speichern von mindestens einem Fehlerkriterium, und
- mindestens eine Detektionseinrichtung (112, 212), eingerichtet zum Detektieren eines Netzfehlers basierend auf dem mindestens einen gespeicherten Fehlerkriterium und dem erfassten Netzstrom und/oder der erfassten Netzspannung,
**dadurch gekennzeichnet, dass** das mindestens eine Fehlerkriterium dazu eingerichtet ist, zwei oder mehr unterschiedliche Fehlerkennlinien für zwei oder mehr unterschiedliche Netzstromverhalten oder Netzspannungsverhalten zu repräsentieren, die jeweils durch unterschiedliche Netzfehler verursacht werden.

2. Fehlerdetektionsvorrichtung (108, 208) nach Anspruch 1, **dadurch gekennzeichnet, dass** die mindestens eine Detektionseinrichtung (112, 212) zum Detektieren eines Netzfehlers basierend auf einem Vergleich zwischen dem mindestens einen gespeicherten Fehlerkriterium und dem erfassten Netzstrom und/oder der erfassten Netzspannung eingerichtet ist.

3. Fehlerdetektionsvorrichtung (108, 208) nach Anspruch 1 oder 2, **dadurch gekennzeichnet, dass**
- das eine der zwei oder mehr unterschiedlichen Fehlerkennlinien dazu eingerichtet ist, insbesondere eine Fehlerstromkennlinie und/oder eine Fehlerspannungskennlinie, und/oder ein Fehlerimpedanzsprung zu repräsentieren, und/oder
- der erfasste Netzstrom dazu eingerichtet ist, einen erfassten Netzstromverlauf zu repräsentieren und/oder die erfasste Netzspannung dazu eingerichtet ist, einen erfassten Netzspannungsverlauf zu repräsentieren.

4. Fehlerdetektionsvorrichtung (108, 208) nach einem der vorherigen Ansprüche,
**dadurch gekennzeichnet, dass**
- das mindestens eine Fehlerkriterium dazu eingerichtet ist, einen durch einen der unterschiedlichen Netzfehler bewirkten Schaltvorgang eines mindestens einen Betriebsmittels (226.1, 226.2, 226.3) des Niederspannungsnetzes (102, 202) zu repräsentieren, und/oder
- das mindestens eine Fehlerkriterium dazu eingerichtet ist, einen durch einen der unterschiedlichen Netzfehler bewirkten Schaltvorgang eines mindestens einen Betriebsmittels (232) einer an das Niederspannungsnetz (102, 202) angeschlossenen Entität (228) zu repräsentieren.

5. Fehlerdetektionsvorrichtung (108, 208) nach Anspruch 4, **dadurch gekennzeichnet, dass** das mindestens eine Betriebsmittel (226.1, 226.2, 226.3) des Niederspannungsnetzes (102, 202) dazu eingerichtet ist, mindestens eine an mindestens einer Niederspannungsverteilsammelschiene (224) der Ortsnetzstation (100, 200) angeschlossene Sicherung (226.1, 226.2, 226.3), insbesondere eine Niederspannungs-Hochleistungs-Sicherung (226.1, 226.2, 226.3), zu repräsentieren.

6. Fehlerdetektionsvorrichtung (108, 208) nach einem der vorherigen Ansprüche,
**dadurch gekennzeichnet, dass**
- die mindestens eine Erfassungseinrichtung (110, 210) ein Strommessmodul (116, 216), insbesondere ein digitales Strommessmodul (116, 216), umfasst, eingerichtet zum Erfassen des über eine Niederspannungsverteilsammelschiene (224) der Ortsnetzstation (100, 200) fließenden Netzstroms, und/oder
- die mindestens eine Erfassungseinrichtung (110, 210) ein Spannungsmessmodul (118, 218), insbesondere ein digitales Spannungsmessmodul (118, 218), umfasst, eingerichtet zum Erfassen der an einer Niederspannungsverteilsammelschiene (224) der Ortsnetzstation (100, 200) anliegenden Netzspannung.

7. Fehlerdetektionsvorrichtung (108, 208) nach einem der vorherigen Ansprüche,
**dadurch gekennzeichnet, dass**
- die Fehlerdetektionsvorrichtung (108, 208) mindestens eine mit der mindestens einen Detektionseinrichtung (112, 212) koppelbare Kommunikationseinrichtung (222) umfasst, eingerichtet zum Aussenden einer Netzfehlernachricht über ein Kommunikationsnetz (234) bei Detektion eines Netzfehlers,
- wobei die Netzfehlernachricht insbesondere eine Netzfehlerart umfasst.

8. Fehlerdetektionsvorrichtung (108, 208) nach einem der vorherigen Ansprüche,
**dadurch gekennzeichnet, dass** die Fehlerdetektionsvorrichtung (108, 208) mindestens eine Fehlerortbestimmungseinrichtung umfasst, zumindest eingerichtet zum Bestimmen eines Abstands zwischen einem Ort des detektierten Netzfehlers und der mindestens einen Fehlerortbestimmungseinrichtung.

9. Ortsnetzstation (100, 200), umfassend:
- mindestens eine Transformatoreinrichtung (106, 206), und
- mindestens eine Fehlerdetektionsvorrichtung (108, 208) nach einem der vorherigen Ansprüche.

10. Verfahren zum Betreiben einer Fehlerdetektionsvorrichtung (108, 208) einer Ortsnetzstation (100, 200) nach einem der Ansprüche 1 bis 8, wobei das Verfahren umfasst:
- Erfassen eines Netzstroms eines an der Ortsnetzstation (100, 200) angeschlossenen Niederspannungsnetzes (102, 202) und/oder einer Netzspannung eines an der Ortsnetzstation (100, 200) angeschlossenen Niederspannungsnetzes (102, 202),
- wobei mindestens ein Fehlerkriterium in mindestens einer Speichereinrichtung (114, 214) gespeichert ist, und
- Detektieren eines Netzfehlers in dem angeschlossenen Niederspannungsnetz (102, 202) basierend auf dem mindestens einen gespeicherten Fehlerkriterium und dem erfassten Netzstrom und/oder der erfassten Netzspannung.

## Claims

1. A fault detection device (108, 208) of a local grid station (100, 200) for detecting a grid fault in at least one low-voltage grid (102, 202) connected to the local grid station (100, 200), comprising
- at least one detection equipment (110, 210) configured to detect a grid current of the connected low-voltage grid (102, 202) and/or a grid voltage of the connected low-voltage grid (102, 202),
- at least one storing equipment (114, 214) configured to store at least one fault criterion, and
- at least one detection equipment (112, 212) configured to detect a grid fault based on the at least one stored fault criterion and the detected grid current and/or the detected grid voltage,
**characterized in that**
- the at least one fault criterion is configured to represent two or more different fault characteristics for two or more different grid current behaviors or grid voltage behaviors, which are each caused by different grid faults.

2. The fault detection device (108, 208) according to claim 1, **characterized in that** the at least one detection equipment (112, 212) is configured to detect a grid fault based on a comparison between the at least one stored fault criterion and the detected grid current and/or the detected grid voltage.

3. The fault detection device (108, 208) according to claim 1 or 2, **characterized in that**
- the one of the two or more different fault characteristics is configured to represent, in particular, a fault current characteristic and/or a fault voltage characteristic, and/or a fault impedance step, and/or
- the detected grid current is configured to represent a detected grid current curve and/or the detected grid voltage is set up to represent a detected grid voltage curve.

4. The fault detection device (108, 208) according to one of the preceding claims,
**characterized in that**
- the at least one fault criterion is configured to represent a switching operation of at least one operating means (226.1, 226.2, 226.3) of the low-voltage grid (102, 202) caused by one of the different grid faults,
and/or
- the at least one fault criterion is configured to represent a switching operation of at least one operating means (232) of an entity (228) connected to the low-voltage grid (102, 202) caused by one of the different grid faults.

5. The fault detection device (108, 208) according to claim 4, **characterized in that** the at least one operating means (226.1, 226.2, 226. 3) of the low-voltage grid (102, 202) is configured to represent at least one fuse (226.1, 226.2, 226.3), in particular, a low-voltage high-power fuse (226.1, 226.2, 226.3), connected to at least one low-voltage distribution busbar (224) of the local grid station (100, 200).

6. The fault detection device (108, 208) according to one of the preceding claims,
**characterized in that**
- the at least one detection equipment (110, 210) comprises a current measurement module (116, 216), in particular, a digital current measurement module (116, 216), configured to detect the grid current flowing via a low-voltage distribution busbar (224) of the local grid station (100, 200),
and/or
- the at least one detection equipment (110, 210) comprises a voltage measurement module (118, 218), in particular, a digital voltage measurement module (118, 218), configured to detect the grid voltage present at a low-voltage distribution busbar (224) of the local grid station (100, 200).

7. The fault detection device (108, 208) according to one of the preceding claims,
**characterized in that**
- the fault detection device (108, 208) comprises at least one communication equipment (222) which can be coupled to the at least one detection equipment (112, 212) and is configured to transmit a grid fault message via a communication grid (234) when a grid fault is detected,
- wherein the grid fault message comprises, in particular, a grid fault type.

8. The fault detection device (108, 208) according to one of the preceding claims, **characterized in that** the fault detection device (108, 208) comprises at least one fault location determining equipment at least configured to determine a distance between a location of the detected grid fault and the at least one fault location determining equipment.

9. A local grid station (100, 200), comprising:
- at least one transformer equipment (106, 206), and
- at least one fault detection device (108, 208) according to one of the preceding claims.

10. A method of operating a fault detection device (108, 208) of a local grid station (100, 200) according to any one of claims 1 to 8, the method comprising:
- detecting a grid current of a low-voltage grid (102, 202) connected to the local grid station (100, 200) and/or a grid voltage of a low-voltage grid (102, 202) connected to the local grid station (100, 200),
- wherein at least one fault criterion is stored in at least one storing equipment (114, 214), and
- detecting a grid fault in the connected low-voltage grid (102, 202) based on the at least one stored fault criterion and the detected grid current and/or the detected grid voltage.

## Revendications

1. Dispositif de détection de défaut (108, 208) d'une station de réseau local (100, 200) pour détecter un défaut de réseau dans au moins un réseau basse tension (102, 202) raccordé à la station de réseau local (100, 200), comprenant :
- au moins un dispositif de détection (110, 210), configuré pour détecter un courant de réseau du réseau basse tension (102, 202) raccordé et/ou une tension de réseau du réseau basse tension (102, 202) raccordé,
- au moins un dispositif de stockage (114, 214), configuré pour stocker au moins un critère de défaut, et
- au moins un dispositif de détection (112, 212), configuré pour détecter un défaut de réseau sur la base du au moins un critère de défaut stocké et du courant de réseau et/ou de la tension de réseau détecté(e),
**caractérisé en ce que**
- le au moins un critère de défaut est configuré pour représenter deux ou plusieurs caractéristiques de défaut différentes pour deux ou plusieurs comportements différents dd courant de réseau ou comportements différents de tension de réseau, qui sont respectivement causés par des défauts de réseau différentes.

2. Dispositif de détection de défaut (108, 208) selon la revendication 1, **caractérisé en ce que** le au moins un dispositif de détection (112, 212) est configuré pour détecter un défaut de réseau sur la base d'une comparaison entre le au moins un critère de défaut stocké et le courant et/ou la tension de réseau détecté(e).

3. Dispositif de détection de défaut (108, 208) selon la revendication 1 ou 2,
**caractérisé en ce que**
- l'une des deux ou plusieurs caractéristiques de défaut différentes est configurée pour représenter en particulier une caractéristique de courant de défaut et/ou une caractéristique de tension de défaut, et/ou un saut d'impédance de défaut, et/ou
- le courant de réseau détecté est configuré pour représenter une courbe de courant de réseau détectée et/ou la tension de réseau détectée est configuré pour représenter une courbe de tension de réseau détectée.

4. Dispositif de détection de défaut (108, 208) selon l'une des revendications précédentes, **caractérisé en ce que**
- l'au moins un critère de défaut est configuré pour représenter une opération de commutation d'au moins un moyen d'exploitation (226.1, 226.2, 226.3) du réseau basse tension (102, 202) provoquée par l'un des différents défauts du réseau, et/ou
- le au moins un critère de défaut est configuré pour représenter une opération de commutation, provoquée par l'un des différents défauts de réseau, d'au moins un moyen d'exploitation (232) d'une entité (228) raccordée au réseau basse tension (102, 202).

5. Dispositif de détection de défaut (108, 208) selon la revendication 4, **caractérisé en ce que** le au moins un équipement (226.1, 226.2, 226. 3) du réseau basse tension (102, 202) est configuré pour représenter au moins un fusible (226.1, 226.2, 226.3) raccordé à au moins un jeu de barres de distribution basse tension (224) de la station de réseau local (100, 200), en particulier un fusible basse tension haute puissance (226.1, 226.2, 226.3).

6. Dispositif de détection de défaut (108, 208) selon l'une des revendications précédentes, **caractérisé en ce que**
- le au moins un dispositif de détection (110, 210) comprend un module de mesure de courant (116, 216), en particulier un module de mesure de courant numérique (116, 216), configuré pour détecter le courant de réseau circulant sur un jeu de barres de distribution basse tension (224) de la station de réseau local (100, 200),
et/ou
- l'au moins un dispositif de détection (110, 210) comprend un module de mesure de tension (118, 218), en particulier un module de mesure de tension numérique (118, 218), configuré pour détecter la tension de réseau appliquée à un jeu de barres de distribution basse tension (224) de la station de réseau local (100, 200).

7. Dispositif de détection de défaut (108, 208) selon l'une des revendications précédentes, **caractérisé en ce que**
- le dispositif de détection de défaut (108, 208) comprend au moins un dispositif de communication (222) couplable à l'au moins un dispositif de détection (112, 212), configuré pour émettre un message de défaut de réseau via un réseau de communication (234) lors de la détection d'un défaut de réseau,
- où le message de défaut de réseau comprend en particulier un type de défaut de réseau.

8. Dispositif de détection de défaut (108, 208) selon l'une des revendications précédentes, **caractérisé en ce que** le dispositif de détection de défaut (108, 208) comprend au moins un dispositif de localisation de défaut, au moins configuré pour déterminer une distance entre un emplacement du défaut de réseau détecté et le au moins un dispositif de localisation de défaut.

9. Station de réseau local (100, 200), comprenant :
- au moins un dispositif de transformateur (106, 206), et
- au moins un dispositif de détection de défaut (108, 208) selon l'une des revendications précédentes.

10. Procédé d'exploitation d'un dispositif de détection de défaut (108, 208) d'une station locale (100, 200) selon l'une des revendications 1 à 8, où le procédé comprend :
- détecter un courant de réseau d'un réseau basse tension (102, 202) raccordé à la station locale (100, 200) et/ou d'une tension de réseau d'un réseau basse tension (102, 202) raccordé à la station locale (100, 200),
- où au moins un critère de défaut est stocké dans au moins un dispositif de stockage (114, 214), et
- détecter un défaut de réseau dans le réseau basse tension (102, 202) raccordé, sur la base du au moins un critère de défaut stocké et du courant de réseau et/ou de la tension de réseau.
